# EUROPÄISCHE PATENTSCHRIFT

(11) **EP 2 737 551 B1**
(45) Veröffentlichungstag und Bekanntmachung des Hinweises auf die Patenterteilung: **24.06.2015**
(21) Anmeldenummer: 12731393.0
(22) Anmeldetag: 26.06.2012
(51) Int. Cl.: H01L 41/083, H01L 41/273

(54) **VERFAHREN ZUR HERSTELLUNG EINES PIEZOELEKTRISCHEN VIELSCHICHTBAUELEMENTS, PIEZOELEKTRISCHES VIELSCHICHTBAUELEMENT ENTHALTEND EIN HILFSMATERIAL, UND VERWENDUNG EINES HILFSMATERIALS ZUR EINSTELLUNG DER BRUCHSPANNUNG EINES PIEZOELEKTRISCHEN VIELSCHICHTBAUELEMENTS**
METHOD FOR PRODUCING A PIEZOELECTRIC MULTILAYER COMPONENT, PIEZOELECTRIC MULTILAYER COMPONENT CONTAINING AN AUXILIARY MATERIAL, AND USE OF AN AUXILIARY MATERIAL FOR SETTING THE BREAKING STRESS OF A PIEZOELECTRIC MULTILAYER COMPONENT
PROCÉDÉ DE FABRICATION D'UN COMPOSANT PIÉZOÉLECTRIQUE STRATIFIÉ, COMPOSANT PIÉZOÉLECTRIQUE STRATIFIÉ CONTENANT UN MATÉRIAU AUXILIAIRE ET UTILISATION D'UN MATÉRIAU AUXILIAIRE POUR MODIFIER LA CONTRAINTE DE RUPTURE D'UN COMPOSANT PHOTOÉLECTRIQUE STRATIFIÉ

(30) Priorität: 29.07.2011 DE 102011109008
(43) Veröffentlichungstag der Anmeldung: 04.06.2014
(73) Patentinhaber: Epcos AG, 81669 München (DE)
(72) Erfinder: DÖLLGAST, Bernhard, A-8530 Deutschlandsberg (AT); ATHENSTAEDT, Wolfgang, A-8010 Graz (AT); OTTLINGER, Marion, A-8530 Deutschlandsberg (AT); FRITZ, Marlene, A-8041 Graz (AT)
(74) Vertreter: Epping - Hermann - Fischer
(86) Internationale Anmeldenummer: PCT/EP2012/062344
(87) Internationale Veröffentlichungsnummer: WO 2013/017342

(56) Entgegenhaltungen:
- EP-A1- 1 702 905
- WO-A1-2009/092584
- DE-A1- 10 164 314
- DE-A1-102007 010 239

## Beschreibung

Es wird ein Verfahren zur Herstellung eines piezoelektrischen Vielschichtbauelements angegeben, bei dem ein Stapel aus piezoelektrischen Grünfolien, mindestens einer Lage enthaltend ein Hilfsmaterial und Schichten aus Elektrodenmaterial gebildet und gesintert wird. Zudem wird ein piezoelektrisches Vielschichtbauelement enthaltend ein Hilfsmaterial, und die Verwendung eines Hilfsmaterials zur Einstellung der Bruchspannung eines piezoelektrischen Vielschichtbauelements beschrieben.

Mit dem Verfahren kann beispielsweise ein Piezoaktor hergestellt werden, der zum Betätigen eines Einspritzventils in einem Kraftfahrzeug eingesetzt werden kann.

Die Zuverlässigkeit von piezoelektrischen Vielschichtbauelementen hängt von der Beherrschung von möglicherweise bei ihrer Herstellung auftretenden Rissen ab. Solche Risse können beispielsweise während thermischen Prozessen, wie Sintern, Metallisieren und Löten oder bei der Polarisation auftreten, da aufgrund von unterschiedlichen Dehnungen in verschiedenen Bereichen des Bauelements elastische Spannungen entstehen. Solche so genannten Entlastungsrisse oder Polungsrisse können weiterhin abknicken, senkrecht zu den Elektroden verlaufen und damit beispielsweise zwei Elektroden überbrücken, was zu einem Kurzschluss und zu einem Versagen des Bauelements führt.

Bekannte Verfahren und Vorrichtungen werden in WO 2009 / 083584 A1, DE 101 64 314 A1, DE 10 2007 010 239 A1 sowie EP 1 702 905 A1 beschrieben.

Es ist eine zu lösende Aufgabe, ein Verfahren zur Herstellung eines piezoelektrischen Vielschichtbauelements anzugeben, das eine erhöhte Zuverlässigkeit aufweist. Diese Aufgabe wird durch ein Verfahren gemäß dem Patentanspruch 1 gelöst. Weitere Ausführungsformen des Verfahrens sind Gegenstand weiterer Patentansprüche.

Es wird ein Verfahren zur Herstellung eines piezoelektrischen Vielschichtbauelements bereitgestellt, das die Schritte umfasst:
A) Bereitstellen eines Elektrodenmaterials und von Grünfolien enthaltend ein piezoelektrisches Material,
B) Bereitstellen eines Hilfsmaterials, das mindestens eine erste und eine zweite Komponente enthält,
C) Bilden eines Stapels, in dem abwechselnd piezoelektrische Grünfolien, mindestens eine Lage enthaltend das Hilfsmaterial und Schichten enthaltend das Elektrodenmaterial übereinander angeordnet sind,
D) Sintern des Stapels,
wobei während des Verfahrensschritts D) die erste und zweite Komponente des Hilfsmaterials chemisch reagieren und die mindestens eine Lage abgebaut wird.

Mit diesem Verfahren wird ein piezoelektrisches Vielschichtbauelement hergestellt, das piezoelektrische Keramikschichten mit dazwischen angeordneten Innenelektroden, sowie mindestens einer Schwächungsschicht aufweist.

Die piezoelektrischen Grünfolien können ein Material aufweisen, das zu Blei-Zirkon-Titanat (PZT) Keramik gesintert werden kann.

"Abwechselnd" in Bezug auf den im Verfahrensschritt C) gebildeten Stapel kann auch bedeuten, dass nicht auf jeder Grünfolie eine Schicht aus Elektrodenmaterial oder eine Lage aus Hilfsmaterial aufgebracht wird. Beispielsweise können einige piezoelektrische Grünfolien übereinander angeordnet sein, zwischen denen sich keine Schichten aus Elektrodenmaterial befinden.

Die Schichten aus Elektrodenmaterial bilden im fertigen Vielschichtbauelement die Innenelektroden und können beispielsweise mittels eines Siebdruckverfahrens als Metallpaste auf die Grünfolien aufgebracht werden.

Werden mehr als eine Lage enthaltend das Hilfsmaterial im Verfahrensschritt C) in dem Stapel angeordnet, können diese in regelmäßigen oder unregelmäßigen Abständen in dem Stapel vorhanden sein. Die Lagen enthaltend das Hilfsmaterial können gemäß einer Ausführungsform parallel oder weitgehend parallel zu zwei Schichten enthaltend Elektrodenmaterial und angrenzend an zwei Grünfolien angeordnet sein.

Mit dem Verfahren kann die Bildung von Bereichen in dem Vielschichtbauelement, in denen sich Risse bilden können, dadurch gezielt gesteuert werden, dass sich die Lage enthaltend das Hilfsmaterial während des Verfahrens abbaut. Durch geeignete Wahl der Komponenten des Hilfsmaterials sind diese in dem fertigen Bauelement weitgehend oder vollständig nicht mehr vorhanden, während sich an der Position der Lage eine Schwächungsschicht ausbildet, in deren Bereich eine Sollbruchstelle in dem Vielschichtbauelement vorhanden ist. Wenn sich Risse ausbilden, treten sie im Bauelement im Bereich der Schwächungsschicht aus. Das Ausbilden unkontrollierter Risse kann somit vermindert oder verhindert werden.

Der im Verfahrensschritt C) gebildete Stapel wird anschließend verpresst und dann die Grünfolien, die zumindest eine Lage enthaltend das Hilfsmaterial und die Schichten aus Elektrodenmaterial im Verfahrensschritt D) gemeinsam gesintert, so dass ein Vielschichtbauelement aus piezoelektrischen Schichten mit dazwischen angeordneten Innenelektroden und mindestens einer Schwächungsschicht entsteht.

Gemäß einer Ausführungsform können das Elektrodenmaterial und das Hilfsmaterial so gewählt werden, dass sie ein gleiches Metall enthalten, das in dem Elektrodenmaterial zu einem geringeren Anteil vorhanden ist als in dem Hilfsmaterial. Der Begriff "Metall" ist in diesem Zusammenhang als allgemeine Bezeichnung zu verstehen, und umfasst somit beispielsweise reine Metalle, Metalllegierungen und Metallkationen, unabhängig von ihren Aggregatszuständen. In dem Hilfsmaterial kann also das Metall in gebundener Form, beispielsweise als Metalloxid, als erste Komponente und in reiner Form als zweite Komponente vorhanden sein.

Unter "zu einem geringeren Anteil" soll verstanden werden, dass die Gesamtkonzentration des Metalls in dem Elektrodenmaterial geringer ist als in dem Hilfsmaterial. Dieser Konzentrationsunterschied bewirkt, dass während des Sinterns im Verfahrensschritt D) eine Diffusion des Metalls von der Lage zu mindestens einer der Schichten enthaltend Elektrodenmaterial stattfinden kann. Diese Diffusion erfolgt dabei durch die der Lage benachbarten piezoelektrischen Schichten. Eine Diffusion des Metalls ist beispielsweise möglich, wenn das Metall in der Dampfphase, als Metalloxid oder als reines Metall vorliegt. Die Mobilität des Metalls in den piezoelektrischen Schichten ist durch den Konzentrationsunterschied als treibende Kraft gegeben.

Die erste Komponente kann in dem Hilfsmaterial zu einem Anteil von 10 bis 90 Gew%, bevorzugt zu 25 bis 75 Gew%, insbesondere zu 50 Gew% vorhanden sein.

In dem Verfahrensschritt D) können gemäß einer Ausführungsform die erste und zweite Komponente zu einer dritten Komponente reagieren und/oder die erste Komponente in eine dritte und eine vierte Komponente zerfallen und die vierte Komponente mit der zweiten Komponente zu der ersten Komponente reagieren. Mit diesen Reaktionen können die erste und die zweite Komponente des Hilfsmaterials nach einer gewissen Zeit weitgehend oder vollständig zu der dritten Komponente reagieren.

Ist beispielsweise die zweite Komponente das Metall, welches auch beispielsweise als Legierung in dem Elektrodenmaterial vorhanden ist, in reiner Form, wird mit dem Verfahren erreicht, dass durch gezielte Zugabe der ersten Komponente zu der zweiten Komponente in der Lage enthaltend das Hilfsmaterial, das reine Metall in dem Hilfsmaterial chemischen Reaktionen unterworfen wird, während das Metall in dem Elektrodenmaterial nicht oder nur zu geringen Anteilen chemisch verändert wird.

Dabei kann die erste Komponente ebenfalls das Metall wie die zweite Komponente und das Elektrodenmaterial enthalten, oder ein von dem Metall der zweiten Komponente und des Elektrodenmaterials unterschiedliches Metall enthalten. Werden unterschiedliche Metalle in der ersten und zweiten Komponente gewählt, so können eine primäre dritte Komponente, das Zerfallsprodukt der ersten Komponente, und eine sekundäre dritte Komponente, das Reaktionsprodukt aus zweiter Komponente vierter Komponente entstehen.

Bei dem Zerfall der ersten Komponente in die dritte und vierte Komponente kann es sich beispielsweise um eine Sauerstoffabspaltung eines Metalloxids handeln. Die erste Komponente kann somit ein Metalloxid sein, in dem das Metall in einer ersten Oxidationsstufe vorliegt, und welches Sauerstoff, also die vierte Komponente, abspaltet. Durch die Abspaltung von Sauerstoff kann sich als dritte Komponente ein Metalloxid, in dem das Metall in einer zweiten Oxidationsstufe vorliegt, bilden. Durch die Sauerstoffabspaltung kann also im Bereich der Lage gezielt das Metall oxidiert werden.

Die genannten Reaktionen, insbesondere der Zerfall der ersten Komponente in die dritte und vierte Komponente, können vor Erreichen der maximalen Sintertemperatur stattfinden. Damit findet die gezielte Oxidation vor Erreichen der maximalen Sintertemperatur und damit vor der Verdichtung des Bauelements statt.

Das Verfahren ermöglicht es also, eine chemische Reaktion, beispielsweise die Oxidation eines Metalls, gezielt räumlich zu beschränken, nämlich auf den Bereich der Lage, die vor der Sinterung das Hilfsmaterial enthielt. Damit kann das reine Metall in der Lage vollständig oxidiert werden, während das Metall in dem Elektrodenmaterial nicht oder kaum angegriffen wird.

In herkömmlichen Methoden, mit denen die Oxidation nur über die Sinteratmosphäre gesteuert wird, ist eine räumlich gezielte Oxidation nicht verwirklichbar, da die Oxidation auch an dem Elektrodenmaterial stattfindet, was unerwünscht ist, da einerseits oxidiertes Elektrodenmaterial wegdiffundieren und damit die Elektrodenschicht auflösen kann und andererseits die Lage, die zur Schwächungsschicht gebildet werden soll, nicht vollständig abgebaut werden kann.

Weiterhin können im Verfahrensschritt D) die dritte Komponente und/oder die erste Komponente zu mindestens einer der Schichten enthaltend Elektrodenmaterial hindiffundieren.

Unter "hindiffundieren" soll verstanden werden, dass die erste und/oder dritte Komponente soweit diffundieren, dass sie von dem Elektrodenmaterial absorbiert werden oder dass sie nur in Richtung des Elektrodenmaterials diffundieren und von dem piezoelektrischen Material, durch das sie diffundieren, absorbiert werden. Die zweite Variante findet beispielsweise dann statt, wenn die erste und dritte Komponente kein Metall enthalten, das in dem Elektrodenmaterial vorhanden ist.

Wenn die Reaktionen vollständig abgelaufen sind, ist nur noch die dritte Komponente vorhanden, die diffundieren kann, es ist aber auch möglich, dass noch Reste an erster Komponente da sind, die dann ebenfalls diffundieren können. Damit können also die gebildeten oder bereits vorhandenen Metalloxide, in denen das Metall in jeweils verschiedenen Oxidationsstufen vorliegt, zu dem Elektrodenmaterial hindiffundieren. In diesem Fall diffundiert das Metall als Kation.

Die Diffusion kann stattfinden, nachdem die Komponenten chemisch reagiert haben, also wenn in der Lage weitgehend nur noch die dritte Komponente vorhanden ist. Die Diffusion kann auch schon beginnen, während die oben genannten Reaktionen der Komponenten noch stattfinden. Weiterhin kann die Diffusion stattfinden, wenn die maximale Sintertemperatur erreicht ist.

Durch die Diffusion kann im Bereich der Lage in dem Stapel eine Schwächungsschicht gebildet werden. Somit wird die Lage, die vor dem Verfahrensschritt D) das Hilfsmaterial enthielt, abgebaut, in dem die erste und zweite Komponente des Hilfsmaterials durch Einwirkung der beim Sintern verwendeten Temperatur zu einer dritten Komponente reagieren und dadurch die Diffusion der ersten und/oder dritten Komponente in Richtung der Elektrodenschichten ermöglichen. Im Bereich der Lage bildet sich also eine poröse Schwächungsschicht, die auch als Schwächungsbereich verstanden werden kann, in der die zweite Komponente vollständig reagiert hat und die dritte Komponente und, wenn noch vorhanden die erste Komponente, wegdiffundiert sind.

Gemäß einer Ausführungsform kann als erste Komponente CuO, als zweite Komponente Cu und als Elektrodenmaterial eine Cu-Legierung ausgewählt werden. Werden die Cu-haltigen Komponenten ausgewählt kann die Diffusion im Verfahrensschritt D) in Form von Kupferoxiden stattfinden. Gemäß einer weiteren Ausführungsform kann als erste Komponente Pb₃O₄, als zweite Komponente Cu und als Elektrodenmaterial eine Cu-Legierung ausgewählt werden.

Gemäß einer Ausführungsform kann das Hilfsmaterial eine fünfte Komponente umfassen, die bei den für das piezoelektrische Material bevorzugten Sintertemperaturen, insbesondere höchstens 1050°C, höchstens eine geringfügige Sinteraktivität aufweist und mit dem eingesetzten piezoelektrischen Material nicht reagiert. Die fünfte Komponente wird vorzugsweise als lose Schüttung in die Hilfsmaterialschicht eingelagert.

Vorzugsweise ist die fünfte Komponente ein keramisches Material.

Vorzugsweise wird die spezifische Oberfläche sowohl des Kupferoxids (CuO) als auch der fünften Komponente so gewählt, dass es zu einer möglichst homogenen Dispergierung kommt. Die spezifische Oberfläche des Kupferoxids bzw. der fünften Komponente beträgt weiter bevorzugt zwischen 8 und 15 m²/g.

In einer Ausführungsform kann die fünfte Komponente ein Element umfassen, das aus der Gruppe gewählt ist, die aus Zirkondioxid, Bariumtitanat und einer Mischung davon besteht. Vorzugsweise umfasst die fünfte Komponente Zirkondioxid.

In einer Ausführungsform kann die fünfte Komponente einen Siliciumgehalt von höchstens 100 ppm besitzen. Hierdurch wird die Sinteraktivität gemindert und folglich die Bruchspannung herabgesetzt.

In einer bevorzugten Ausführungsform wird als erste Komponente CuO, als zweite Komponente Cu, als fünfte Komponente ZrO₂ und als Elektrodenmaterial eine Cu-Legierung ausgewählt.

Weitere Metallsysteme sind ebenso denkbar, wenn dafür beispielsweise eine erste Komponente gewählt werden kann, die Sauerstoff abspaltet.

Nach der Sinterung können weiterhin auf zwei gegenüberliegenden Außenflächen des Vielschichtbauelements Außenelektroden aufgebracht werden. Dazu kann beispielsweise auf dem Stapel eine Grundmetallisierung eingebrannt werden. Die Innenelektroden sind vorzugsweise entlang der Stapelrichtung des Bauelements abwechselnd mit den Außenelektroden verbunden. Dazu sind die Innenelektroden beispielsweise abwechselnd bis zu einer der Außenelektroden geführt und weisen zur zweiten Außenelektrode einen Abstand auf. Auf diese Weise sind die Innenelektroden einer Polarität über eine gemeinsame Außenelektrode elektrisch miteinander verbunden.

In einem weiteren Aspekt der Erfindung wird ein piezoelektrisches Vielschichtbauelement bereitgestellt, das mehrere alternierende Schichten aus Elektrodenmaterial und piezoelektrischer Keramik sowie mindestens eine Schicht aus Hilfsmaterial mit gegenüber den übrigen Schichten aus Elektrodenmaterial verringerter Bruchlast umfasst, wobei das Hilfsmaterial eine fünfte Komponente, wie vorstehend definiert, umfasst.

Vorzugsweise besitzt das Vielschichtbauelement eine Bruchspannung von 10 MPa bis 25 MPa, weiter bevorzugt 10 MPa bis 20 MPa, insbesondere bevorzugt 10 MPa bis 15 MPa. Durch eine geringere maximale Bruchlast wird die Zuverlässigkeit des Bauteils erhöht. Andererseits kommt es bei einer Bruchlast von weniger als 10 MPa bereits bei den thermischen Prozessen und beim Schleifen zu Brüchen, wodurch die Ausbeute verringert wird.

Ein weiterer Aspekt der Erfindung zielt auf die Verwendung von ZrO₂, BaTiO₃ oder einer Mischung davon in der Hilfsmaterialschicht eines piezoelektrischen Vielschichtbauelements zur Verringerung der Bruchspannung ab.

Im Folgenden wird das angegebene Verfahren und seine vorteilhaften Ausgestaltungen anhand von schematischen und nicht maßstabsgetreuen Figuren sowie anhand eines Ausführungsbeispiels erläutert. Es zeigen:
- Figur 1: die schematische Seitenansicht eines durch das Verfahren hergestellten Vielschichtbauelements.
- Figur 2: a) und b) zeigen vergrößerte schematische Seitenansichten eines Vielschichtbauelements.
- Figur 3: a) und b) zeigen Schliffbilder eines Bauteils mit Hilfsmaterialschicht jeweils mit ZrO₂ und ohne fünfte Komponente.
- Figur 4: a) und b) zeigen ein Bauteil mit Hilfsmaterialschicht jeweils mit ZrO₂ und ohne fünfte Komponente nach Bruchtest.
- Figur 5: a) bis c) zeigen eine Rasterelektronenmikroskopie-Aufnahme eines Bauteils mit ZrO₂ in der Hilfsmaterialschicht sowie eine EDX-Analyse und Kartendarstellung der Aufnahme.
- Figur 6: a) bis c) zeigen eine Rasterelektronenmikroskopie-Aufnahme einer Bruchfläche eines Bauteils mit ZrO₂ in der Hilfsmaterialschicht sowie eine EDX-Analyse und Kartendarstellung der Aufnahme.
- Figur 7: a) bis c) zeigen eine Rasterelektronenmikroskopie-Aufnahme einer Bruchfläche eines Bauteils ohne fünfte Komponente in der Hilfsmaterialschicht sowie eine EDX-Analyse und Kartendarstellung der Aufnahme.
- Figur 8: a) bis c) zeigen Rasterelektronenmikroskopie-Aufnahmen einer Bruchfläche eines Bauteils ohne fünfte Komponente in der Hilfsmaterialschicht, wobei Unterschiede der Kornstruktur erläutert werden.
- Figur 9: a) und b) zeigen Schliffbilder eines Bauteils mit Hilfsmaterialschicht jeweils mit BaTiO₃ und ohne fünfte Komponente.
- Figur 10: a) und b) zeigen ein Bauteil mit Hilfsmaterialschicht jeweils mit BaTiO₃ und ohne fünfte Komponente nach Bruchtest.
- Figur 11: a) bis c) zeigen eine Rasterelektronenmikroskopie-Aufnahme eines Bauteils mit BaTiO₃ in der Hilfsmaterialschicht sowie Kartendarstellung der Aufnahme und eine EDX-Analyse.
- Figur 12: a) bis c) zeigen eine Rasterelektronenmikroskopie-Aufnahme einer Bruchfläche eines Bauteils mit BaTiO₃ in der Hilfsmaterialschicht sowie eine EDX-Analyse und Kartendarstellung der Aufnahme.

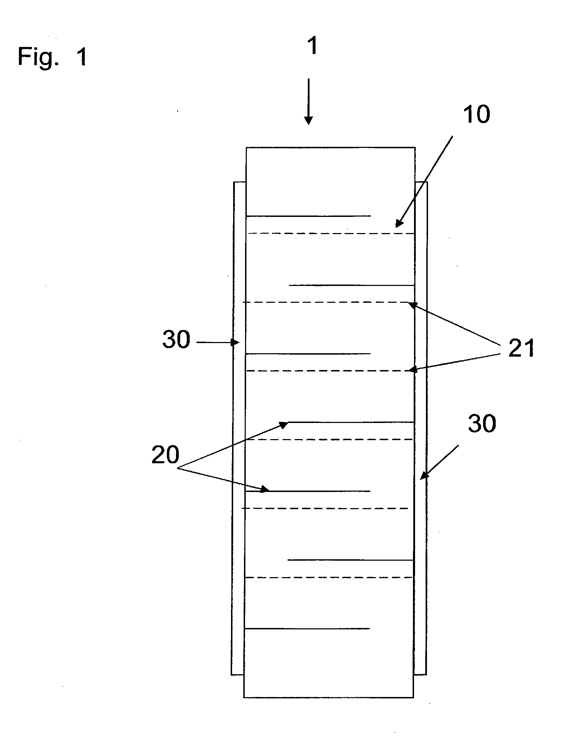

Figur 1 zeigt eine schematische Seitenansicht eines piezoelektrischen Vielschichtbauelements in Form eines Piezoaktors. Das Bauelement weist einen Stapel 1 aus übereinander angeordneten piezoelektrischen Schichten 10 und dazwischen liegenden Innenelektroden 20 auf. Die Innenelektroden 20 sind als Elektrodenschichten ausgebildet. Die piezoelektrischen Schichten 10 und die Innenelektroden 20 sind übereinander angeordnet. Zwischen piezoelektrischen Schichten 10 und parallel zu den Innenelektroden 20 sind Schwächungsschichten 21 in Figur 1 gezeigt. Die Schwächungsschicht 21 ist als Bereich zu verstehen, in dem Sollbruchstellen in dem Bauelement vorhanden sind.

Die piezoelektrischen Schichten 10 enthalten ein keramisches Material, zum Beispiel Blei-Zirkon-Titanat (PZT) oder eine bleifreie Keramik. Das Keramikmaterial kann auch Dotierstoffe enthalten. Die Innenelektroden 20 enthalten beispielsweise eine Mischung oder eine Legierung aus Cu und Pd.

Zur Herstellung des Stapels 1 werden beispielsweise Grünfolien, die ein Keramikpulver, ein organisches Bindemittel und ein Lösungsmittel enthalten, durch Folienziehen oder Foliengießen hergestellt. Auf einige der Grünfolien wird zur Bildung der Innenelektroden 20 eine Elektrodenpaste mittels Siebdruck aufgebracht. Weiterhin werden Lagen enthaltend ein Hilfsmaterial mit einer ersten und zweiten Komponente zur Bildung von Schwächungsschichten 21 auf eine oder mehrere Grünfolien aufgebracht. Die Grünfolien werden entlang einer Längsrichtung übereinander gestapelt und verpresst. Aus dem Folienstapel werden die Vorprodukte der Bauelemente in der gewünschten Form herausgetrennt. Schließlich wird der Stapel aus piezoelektrischen Grünfolien, Lagen aus Hilfsmaterial und Elektrodenschichten gesintert. Nach dem Sintern werden weiterhin Außenelektroden 30 angebracht, die auch in Figur 1 gezeigt sind.

In der hier gezeigten Ausführungsform sind die Außenelektroden 30 auf gegenüberliegenden Seitenflächen des Stapels 1 angeordnet und verlaufen streifenförmig entlang der Stapelrichtung. Die Außenelektroden 30 enthalten beispielsweise Ag oder Cu und können als Metallpaste auf den Stapel 1 aufgebracht und eingebrannt werden.

Die Innenelektroden 20 sind entlang der Stapelrichtung abwechselnd bis zu einer der Außenelektroden 30 geführt und von der zweiten Außenelektrode 30 beabstandet. Auf diese Weise sind die Außenelektroden 30 entlang der Stapelrichtung abwechselnd mit den Innenelektroden 20 elektrisch verbunden. Zur Herstellung des elektrischen Anschlusses kann auf die Außenelektroden 30 ein Anschlusselement (hier nicht gezeigt), z. B. durch Löten, aufgebracht werden.

Anhand des folgenden Ausführungsbeispiels soll die Herstellung des in Figur 1 gezeigten Vielschichtbauelements, welches Schwächungsschichten 21 enthält, näher erläutert werden:
Zur Bildung des Stapels 1 wird auf mindestens eine Grünfolie eine Lage enthaltend ein Hilfsmaterial aufgebracht. Als Elektrodenmaterial wird eine CuPd-Paste auf Grünfolien aufgedruckt. Das Hilfsmaterial enthält CuO als erste Komponente und Cu als zweite Komponente, wobei CuO mit einem Anteil von 10 bis 90 Gew%, bevorzugt 25 bis 75 Gew%, insbesondere von 50 Gew% in dem Hilfsmaterial vorhanden ist.

Wird nun beim Sintern eine Temperatur von ca. 800°C erreicht, bei der noch keine Verdichtung des Stapels 1 eintritt, zerfällt das CuO in Cu₂O (dritte Komponente) und O₂ (vierte Komponente) und gleichzeitig reagieren Cu und CuO zu Cu₂O. Der durch Abspaltung erzeugte Sauerstoff O₂ oxidiert nun das metallische Cu zu CuO welches wiederum zu Cu₂O weiterreagieren kann. Diese Oxidation findet also gezielt im Bereich der Lage statt, während das Cu in der CuPd-Paste weitgehend unverändert bleibt.

Während diese Reaktionen ablaufen und/oder nachdem sie stattgefunden haben diffundiert das gebildete Cu₂O und - soweit noch vorhanden - das CuO zu den Elektrodenschichten 20, die räumlich am nächsten liegen, hin. Dadurch wird die Lage enthaltend das Hilfsmaterial abgebaut und somit die Schwächungsschicht 21 gebildet. Die Porosität der Schwächungsschicht kann beispielsweise durch die Korngröße des verwendeten CuO eingestellt beziehungsweise beeinflusst werden.

Die Diffusion des oder der Kupferoxide CuO und Cu₂O durch die piezoelektrischen Schichten hindurch funktioniert dabei besonders gut, da Cu-Kationen besser diffundieren als reines Cu. Die Diffusion an sich wird begünstigt durch den Konzentrationsunterschied von Cu, das in der Lage enthaltend das Hilfsmaterial beziehungsweise enthaltend die aus dem Hilfsmaterial gebildeten Komponenten, und in dem Elektrodenmaterial vorhanden ist. Die Diffusion kann bei der maximalen Sintertemperatur, beispielsweise bei 1200°C stattfinden.

Somit wird das Cu in der Lage, die vor dem Sintern das Hilfsmaterial enthält, vollständig abgebaut. Das Kupferoxid, das zu den Elektrodenschichten diffundiert ist, wird dort zunächst absorbiert und dann der Sauerstoff wieder abgespalten, so dass reines Cu zurückbleibt, das sich an die CuPd-Legierung des Elektrodenmaterials anlagert.

In einem alternativen Ausführungsbeispiel kann als erste Komponente Pb₃O₄ anstatt CuO ausgewählt werden. Dieses zerfällt in PbO und O₂, welches wiederum das Cu oxidieren kann. Die Bleioxide werden nicht von dem Elektrodenmaterial sondern von dem piezoelektrischen Material absorbiert und somit Teil der keramischen Schichten werden. Das von dem entstehenden Sauerstoff oxidierte Cu diffundiert wie oben beschrieben bis zu dem Elektrodenmaterial hin und wird dort absorbiert.

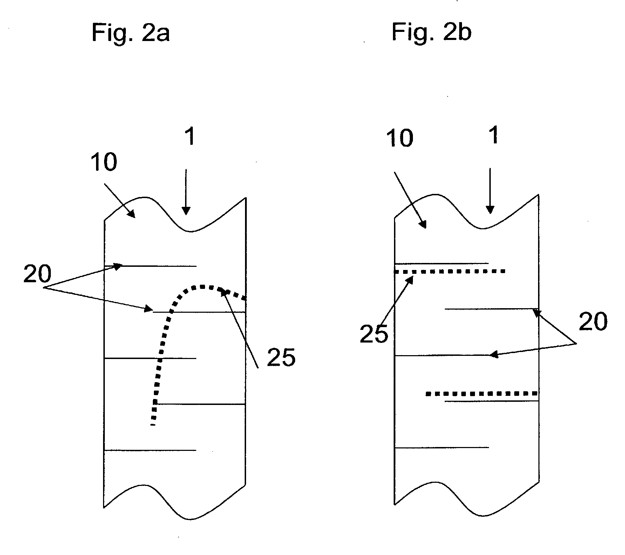

Figur 2a zeigt einen vergrößerten Ausschnitt der schematischen Seitenansicht des Vielschichtbauelements. Anhand dieser Figur soll die Rissbildung in Vielschichtbauelementen erläutert werden.

Das Bauelement dehnt sich beim Anlegen einer Spannung zwischen die Außenelektroden 30 in Längsrichtung aus. In einer so genannten aktiven Zone, in der sich in Stapelrichtung benachbarte Innenelektroden 20 überlappen, entsteht beim Anlegen einer Spannung an die Außenelektroden 30 ein elektrisches Feld, sodass sich die piezoelektrischen Schichten 10 in Längsrichtung ausdehnen. In inaktiven Zonen in denen sich benachbarte Elektrodenschichten 20 nicht überlappen, dehnt sich der Piezoaktor nur geringfügig aus.

Aufgrund der unterschiedlichen Ausdehnung des Bauelements in den aktiven und inaktiven Zonen treten mechanische Spannungen im Stapel 1 auf. Derartige Spannungen können zu Polungs- und/oder Entlastungsrissen 25 im Stapel 1 führen.

Die Figur 2a zeigt einen Ausschnitt aus einem Stapel 1 aus piezoelektrischen Schichten 10 und Innenelektroden 20, bei dem ein Riss 25 im Stapel 1 entstanden ist. Der Riss 25 verläuft innerhalb der inaktiven Zone parallel zu den Innenelektroden 20, knickt beim Übergang in die aktive Zone ab und verläuft in der aktiven Zone durch benachbarte Innenelektroden 20 unterschiedlicher Polarität hindurch. Dies kann zu einem Kurzschluss der Innenelektroden 20 führen.

Figur 2b zeigt einen Ausschnitt aus einem Stapel 1 aus piezoelektrischen Schichten 10 und Innenelektroden 20, in dem ebenfalls ein Riss 25 entstanden ist. Hier verläuft der Riss 25 parallel zu den Innenelektroden 20. Bei einem derartigen Verlauf von Rissen 25 ist die Gefahr von Kurzschlüssen verringert.

Um einen derartigen Verlauf von Rissen 25 zu begünstigen, wird das Vielschichtbauelement gemäß dem oben genannten Verfahren hergestellt, so dass sich die Risse 25 gezielt im Bereich der Schwächungsschicht 21, in der eine Sollbruchstelle vorhanden ist, ausbilden.

In einem dritten Ausführungsbeispiel wird eine Bedruckungspaste (Hilfsmaterial) mit einem Anteil von 25 Gew.-% Cu, 25 Gew.-% CuO und 4,5 Gew.-% ZrO₂ (Rest organisches Bindemittel) verwendet. Die Bedruckung der nächstliegenden Elektrodenschichten erfolgt mit einer Paste, deren Metallgehalt sich aus 90 Gew.-% Cu und 10 Gew.-% Pd zusammensetzt. Der Zirkondioxid-Zusatz erfolgt nur in Verbindung mit dem Hilfsmaterial. Die bedruckten Keramikschichten werden laminiert und verpresst. Danach wird der gepresste Block in Bauteile vereinzelt. Die Entkohlung (Entbinderung) dieser Bauteile erfolgt in einer für kupferhaltige Elektroden und bleihaltige Keramik zuträglichen Atmosphäre bei Temperaturen, die ein kohlenstoffarmes Bauteil erzeugen. Die Sinterung erfolgt ebenfalls atmosphärengesteuert bei einer Höchsttemperatur von 1010°C.

Das verwendete ZrO₂ weist eine spezifische Oberfläche von 13 m²/g, d10V = 0,095 µm, d50V = 0,55 µm und d90V = 2,15 µm auf. Der Si-Gehalt des Materials betrug 78 ppm.

Von den erhaltenen Bauelementen sowie von Vergleichsbauelementen ohne fünfte Komponente (ZrO₂) im Hilfsmaterial wurden Schliffbilder angefertigt und diese sowohl lichtmikroskopisch als auch rasterelektronenmikroskopisch untersucht. Zudem wurde die Bruchspannung getestet.

In einem Rasterelektronenmikroskop wird die zu untersuchende Probenoberfläche mit einem sehr fein fokussierten Elektronenstrahl abgerastert. Die Elektronen lösen in der Probenoberfläche verschiedene Signale aus, z.B. Sekundärelektronen, Rückstreuelektronen oder charakteristische Röntgenstrahlung. Diese können durch geeignete Detektoren registriert werden. Parallel zu dem Raster auf der Probe wird ein Bildschirm abgerastert und die Helligkeit durch die Intensität des Signals aus der Probe gesteuert. So erhält man mit Sekundärelektronen eine hoch aufgelöste Abbildung der Probenoberfläche (Topographiekontrast), während man mit Rückstreuelektronen Bereiche unterschiedlicher chemischer Zusammensetzung sichtbar machen kann (Materialkontrast).

Die auf die Probenoberfläche treffenden Elektronen regen die dort vorhandenen Atome zur Aussendung charakteristischer Röntgenstrahlung an. Die Energie dieser Strahlung ist charakteristisch für jedes Element und ihre Intensität ein Maß für dessen Gehalt in der untersuchten Probenstelle (Elektronenstrahlmikroanalyse, EDX). So kann die Elementzusammensetzung in kleinen Bereichen (Auflösung etwa ein bis einige Mikrometer) bestimmt werden.

Wird nun die beim Abrastern einer Probenfläche entstehende charakteristische Röntgenstrahlung punktweise registriert, kann die Konzentrationsverteilung von Elementen über der untersuchten Probenoberfläche sichtbar gemacht werden (Elementverteilungsbilder, EDX-Kartendarstellung bzw "-Mapping"). Neben der punkt- und flächenförmigen Analyse kann der Konzentrationsverlauf von Elementen auch entlang einer Linie dargestellt werden (Linienabtastung bzw. "Line-Scan").

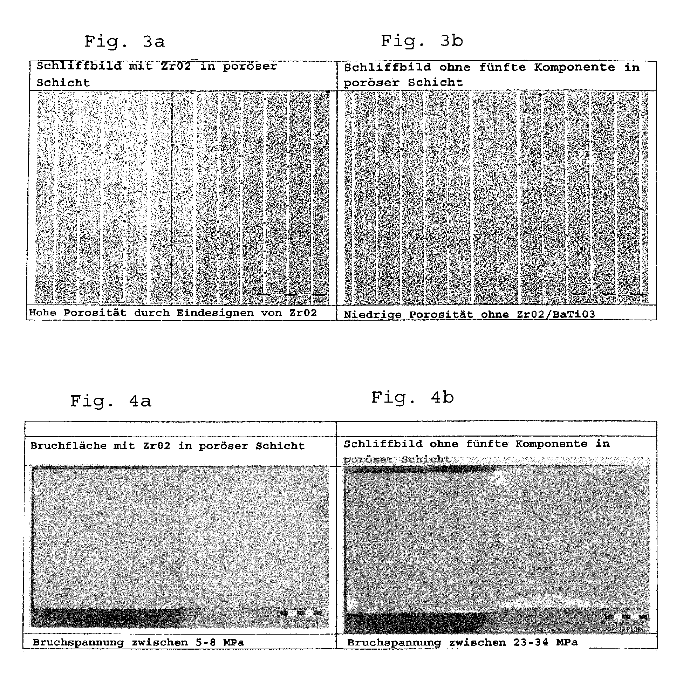

Figur 3 a) und b) zeigen Schliffbilder eines Bauteils mit Hilfsmaterialschicht jeweils mit ZrO₂ und ohne fünfte Komponente. In Fig. 3 a) ist eine Hilfsmaterialschicht in der Mitte des Bauteils mit dunkler Farbe zu sehen, die eine hohe Porosität angibt. In Fig. 3 b) fehlt die dunkle Farbe.

Figur 4 a) und b) zeigen ein Bauteil mit Hilfsmaterialschicht jeweils mit ZrO₂ und ohne fünfte Komponente nach Bruchtest. Das Bauteil aus Fig. 3a), das ZrO₂ in der Hilfsmaterialschicht umfasst, zeichnet sich durch eine niedrige Bruchspannung von 5 - 8 MPa aus, während das Bauteil ohne fünfte Komponente eine Bruchspannung zwischen 23 bis 34 MPa aufwies.

Zur Feststellung der Bruchspannung (Spannung bei Bruch; Einheit: MPa) wird die Methode des Vierpunktbiegebruchs angewendet. Das Bauteil wird zentrisch so eingelegt, dass eine kleine Isozone oben auf der rechten Seite sichtbar wird. Der Lastrollenabstand wird auf den vorgegebenen Wert von 20 mm zentrisch eingestellt. Die Geschwindigkeit ist mit 5 mm/min definiert. Die ermittelte Bruchkraft wird unter Angabe der Bauteilgeometrie in eine Bruchspannung umgerechnet. Geräte zur Durchführung des vorstehenden Messverfahrens sind kommerziell erhältlich. Beispielsweise werden von der Firma Zwick/Roell solche Geräte angeboten.

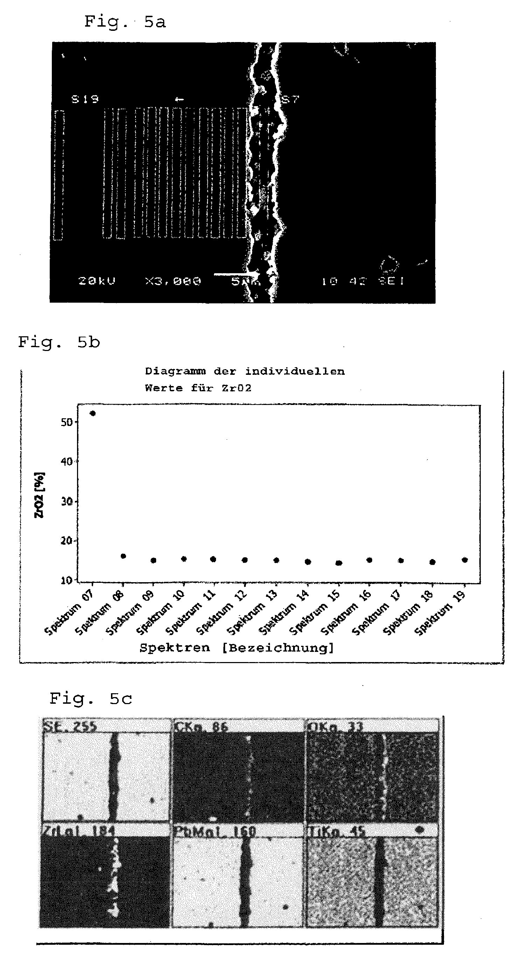

Figur 5 a) bis c) zeigen eine Rasterelektronenmikroskopie-Aufnahme eines Bauteils mit ZrO₂ in der Hilfsmaterialschicht sowie eine EDX-Analyse und Kartendarstellung der Aufnahme. In der Kartendarstellung zeigt die Hellfärbung eine hohe Konzentration eines Elements an. Aus der EDX-Analyse (Fig. 5 b) und Kartendarstellung (Fig. 5 c) ergibt sich, dass sich das ZrO₂ ausschließlich in der porösen Schicht ansammelt. Ein Eindiffundieren in die Keramik und eine Veränderung der analytischen Zusammensetzung der PZT-Keramik ist nicht erkennbar.

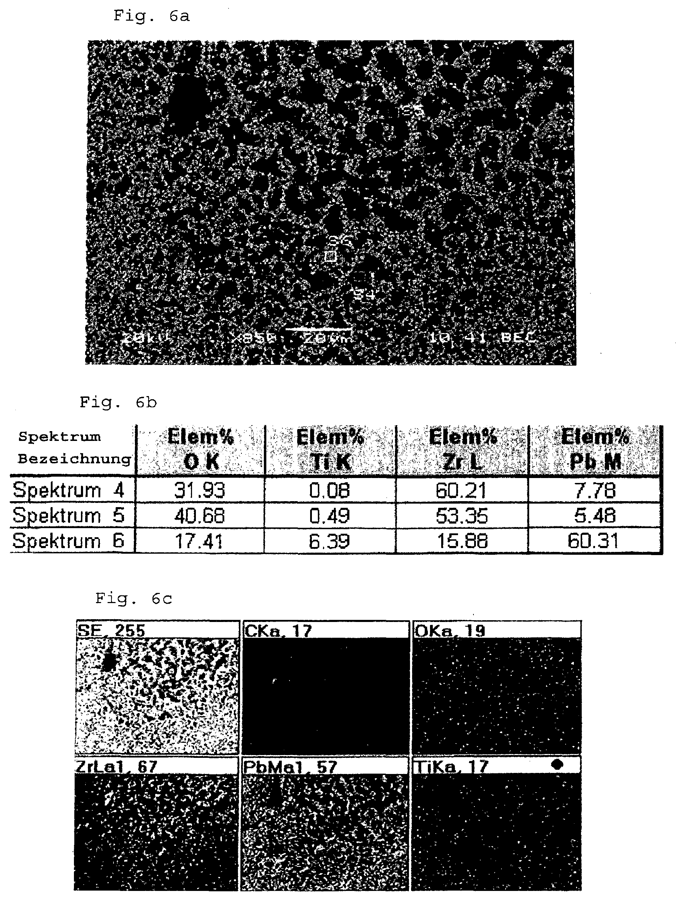

Figur 6 a) bis c) zeigen eine Rasterelektronenmikroskopie-Aufnahme einer Bruchfläche eines Bauteils mit ZrO₂ in der Hilfsmaterialschicht sowie eine EDX-Analyse und Kartendarstellung der Aufnahme. Auf der Bruchfläche liegt deutlich erkennbar ZrO₂. Dies wird durch die EDX-Analyse (Fig. 6 b) und Kartendarstellung (Fig. 6 c) bestätigt.

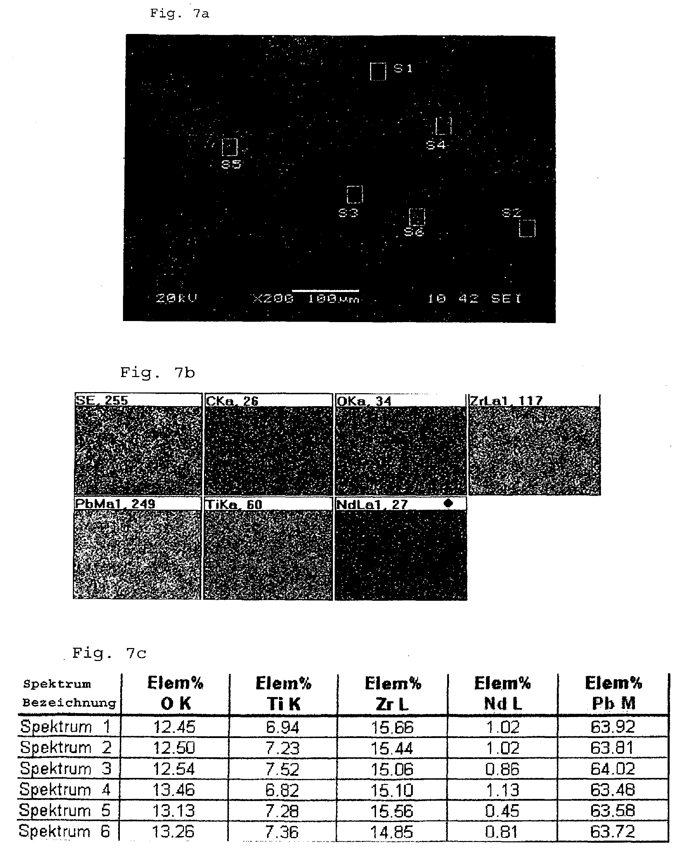

Figur 7 a) bis c) zeigen eine Rasterelektronenmikroskopie-Aufnahme einer Bruchfläche eines Bauteils ohne fünfte Komponente in der Hilfsmaterialschicht sowie eine EDX-Analyse und Kartendarstellung der Aufnahme. Sowohl in der Kartendarstellung als auch in der EDX-Analyse ist erkennbar, dass es keine analytischen Unterschiede zwischen den "hellen" und "dunklen" Stellen auf der Bruchfläche gibt.

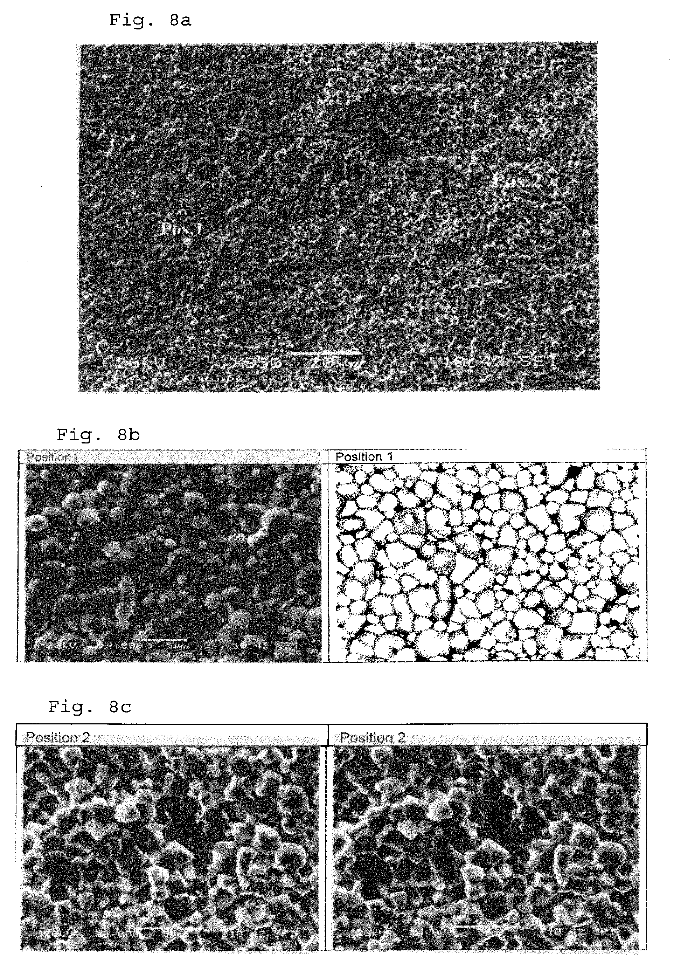

Figur 8 a) bis c) zeigen Rasterelektronenmikroskopie-Aufnahmen einer Bruchfläche eines Bauteils ohne fünfte Komponente in der Hilfsmaterialschicht, wobei Unterschiede der Kornstruktur erläutert werden. Offenbar entsteht die hohe Bruchkraft durch die Bereiche mit hoher Versinterung der Körner (Fig. 8c). In einem vierten Ausführungsbeispiel wird eine Bedruckungspaste (Hilfsmaterial) mit einem Anteil von 25 Gew.-% Cu, 25 Gew.-% CuO und 4,5 Gew.-% BaTiO₃ (Rest organisches Bindemittel) verwendet. Die Bedruckung der nächstliegenden Elektrodenschichten erfolgt mit einer Paste, deren Metallgehalt sich aus 90 Gew.-% Cu und 10 Gew.-% Pd zusammensetzt. Der Bariumtitanat-Zusatz erfolgt nur in Verbindung mit dem Hilfsmaterial. Die bedruckten Keramikschichten werden laminiert und verpresst. Danach wird der gepresste Block in Bauteile vereinzelt. Die Entkohlung (Entbinderung) dieser Bauteile erfolgt in einer für kupferhaltige Elektroden und bleihaltige Keramik zuträglichen Atmosphäre bei Temperaturen, die ein kohlenstoffarmes Bauteil erzeugen. Die Sinterung erfolgt ebenfalls atmosphärengesteuert bei einer Höchsttemperatur von 1010°C.

Das verwendete BaTiO₃ weist eine spezifische Oberfläche von 1,5 m²/g, d50V = 1,2 µm auf. Der Si-Gehalt beträgt weniger als 100 ppm.

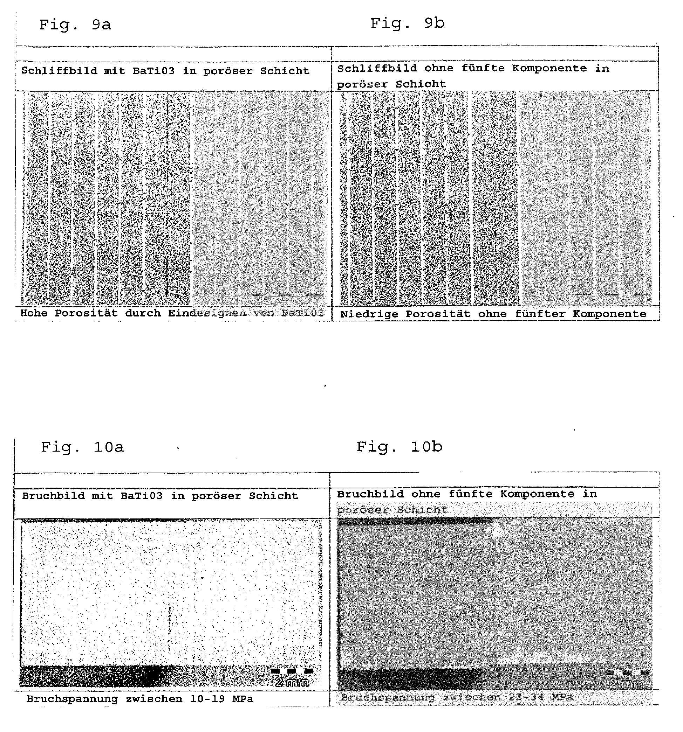

Figur 9 a) und b) zeigen Schliffbilder eines Bauteils mit Hilfsmaterialschicht jeweils mit BaTiO₃ und ohne fünfte Komponente. Der höhere Schwärzungsgrad der Hilfsmaterialschicht in der Mitte von Fig. 9a) gibt die höhere Porosität der Schicht verglichen mit derjenigen von Fig. 9 b) an.

Figur 10 a) und b) zeigen ein Bauteil mit Hilfsmaterialschicht jeweils mit BaTiO₃ und ohne fünfte Komponente nach Bruchtest. Die Bruchspannung des Bauteils mit Bariumtitanat in der Hilfsmaterialschicht beträgt 10 - 19 MPa, während die Bruchspannung der Hilfsmaterialschicht ohne fünfte Komponente in der Hilfsmaterialschicht 23 - 34 MPa beträgt.

Die Bruchfläche an der porösen Schicht mit Bariumtitanat zeigt regelmäßig verteilte helle Ablagerungen, die im REM untersucht werden.

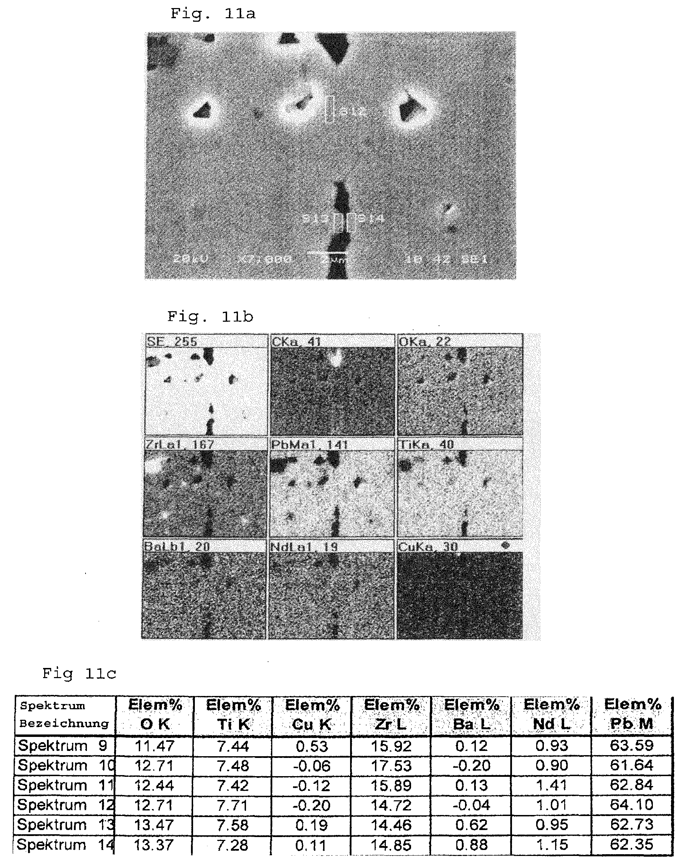

Figur 11 a) bis c) zeigen eine Rasterelektronenmikroskopie-Aufnahme eines Bauteils mit BaTiO₃ in der Hilfsmaterialschicht sowie Kartendarstellung der Aufnahme und eine EDX-Analyse.

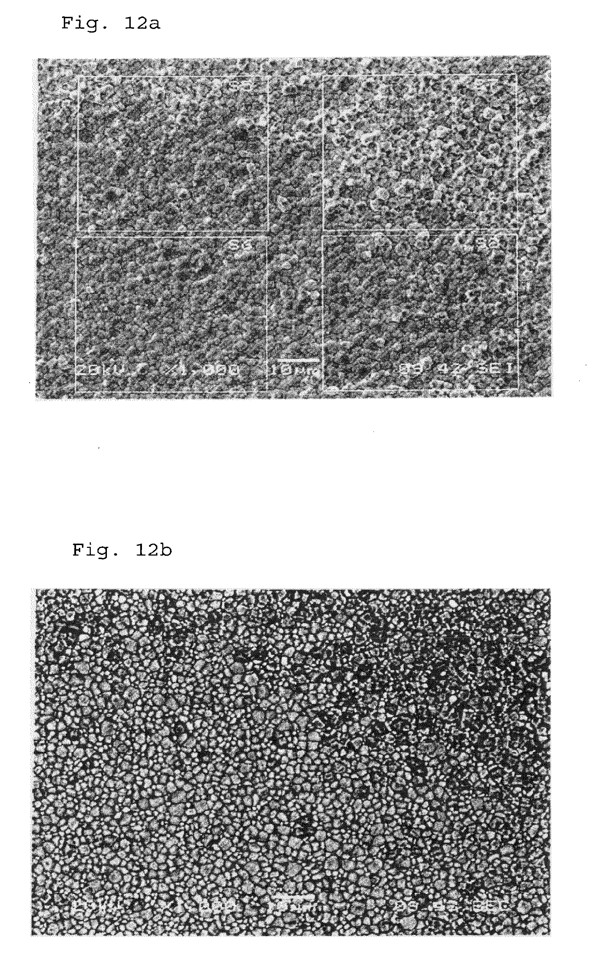

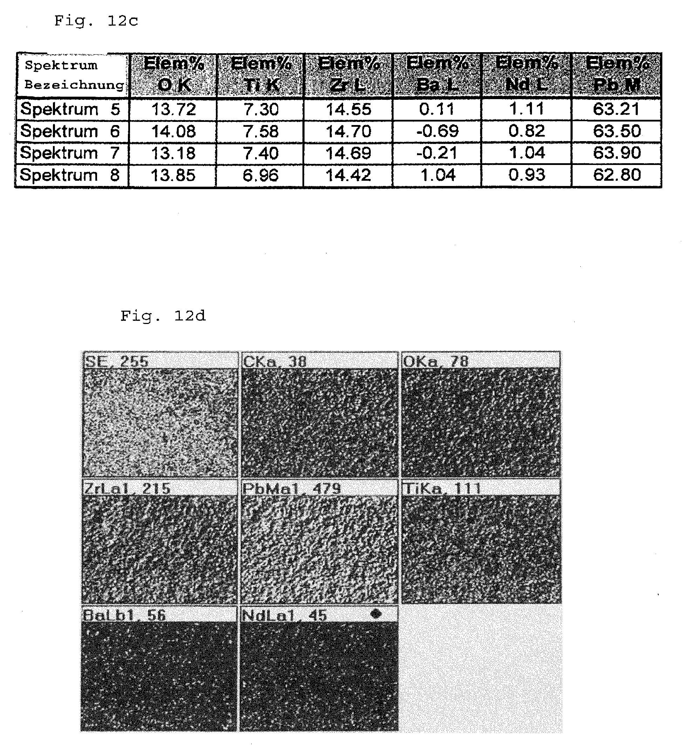

Figur 12 a) bis c) zeigen eine Rasterelektronenmikroskopie-Aufnahme einer Bruchfläche eines Bauteils mit BaTiO₃ in der Hilfsmaterialschicht sowie eine EDX-Analyse und Kartendarstellung der Aufnahme.

Die REM-Aufnahmen zeigen, dass die zugegebene Konzentration BaTiO₃ in geringerem Ausmaß als ZrO₂ die gewünschte Stützfunktion einnimmt. Ein großer Anteil des Hilfsmaterials ist in die Keramik eindiffundiert. Der Nachweis einer erhöhten Ba-Konzentration im Bereich der porösen Schicht kann nur lokal erfolgen. Ein starker Versinterungsgrad der Körner, wie ohne fünfte Komponente sichtbar, ist nicht zu beobachten.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

### Bezugszeichenliste

- 1: Stapel
- 10: piezoelektrische Schicht
- 20: Innenelektrode
- 21: Schwächungsschicht
- 25: Riss
- 30: Außenelektroden

## Patentansprüche

1. Verfahren zur Herstellung eines piezoelektrischen Vielschichtbauelements umfassend die Schritte:
A) Bereitstellen eines Elektrodenmaterials und von Grünfolien enthaltend ein piezoelektrisches Material,
B) Bereitstellen eines Hilfsmaterials, das mindestens eine erste und eine zweite Komponente enthält,
C) Bilden eines Stapels (1), in dem abwechselnd piezoelektrische Grünfolien, mindestens eine Lage enthaltend das Hilfsmaterial und Schichten enthaltend das Elektrodenmaterial übereinander angeordnet sind,
D) Sintern des Stapels (1),
wobei während des Verfahrensschritts D) die erste und zweite Komponente des Hilfsmaterials chemisch reagieren und die mindestens eine Lage abgebaut wird.

2. Verfahren nach dem vorhergehenden Anspruch, wobei das Elektrodenmaterial und das Hilfsmaterial so gewählt werden, dass sie ein gleiches Metall enthalten, das in dem Elektrodenmaterial zu einem geringeren Anteil vorhanden ist als in dem Hilfsmaterial.

3. Verfahren nach einem der vorhergehenden Ansprüche, wobei im Verfahrensschritt D) die erste und zweite Komponente zu einer dritten Komponente reagieren und/oder die erste Komponente in eine dritte und eine vierte Komponente zerfällt und die vierte Komponente mit der zweiten Komponente zu der ersten Komponente reagiert.

4. Verfahren nach dem vorhergehenden Anspruch, wobei im Verfahrensschritt D) die dritte Komponente und/oder die erste Komponente zu mindestens einer der Schichten enthaltend Elektrodenmaterial (20) hindiffundieren.

5. Verfahren nach dem vorhergehenden Anspruch, wobei durch die Diffusion im Bereich der Lage in dem Stapel (1) eine Schwächungsschicht (21) gebildet wird.

6. Verfahren nach einem der vorhergehenden Ansprüche, wobei als erste Komponente CuO, als zweite Komponente Cu und als Elektrodenmaterial eine Cu-Legierung ausgewählt wird.

7. Verfahren nach einem der vorhergehenden Ansprüche, wobei das Hilfsmaterial eine fünfte Komponente umfasst, die bei den für das piezoelektrische Material bevorzugten Sintertemperaturen, insbesondere höchstens 1050°C, höchstens eine geringfügige Sinteraktivität aufweist und mit dem eingesetzten piezoelektrischen Material nicht reagiert.

8. Verfahren nach Anspruch 7, wobei die fünfte Komponente ein keramisches Material ist.

9. Verfahren nach Anspruch 7 oder 8, wobei die fünfte Komponente ein Element umfasst, das aus der Gruppe gewählt ist, die aus Zirkondioxid, Bariumtitanat und einer Mischung davon besteht.

10. Verfahren nach einem der Ansprüche 7 bis 9, wobei die fünfte Komponente Zirkondioxid umfasst.

11. Verfahren nach einem der Ansprüche 7 bis 10, wobei die fünfte Komponente einen Siliciumgehalt von höchstens 100 ppm besitzt.

12. Verfahren nach einem der Ansprüche 7 bis 11, wobei als erste Komponente CuO, als zweite Komponente Cu, als fünfte Komponente ZrO₂ und als Elektrodenmaterial eine Cu-Legierung ausgewählt wird.

13. Piezoelektrisches Vielschichtbauelement umfassend mehrere alternierende Schichten aus Elektrodenmaterial und piezoelektrischer Keramik und mindestens eine Schicht aus Hilfsmaterial mit gegenüber den übrigen Schichten aus Elektrodenmaterial verringerter Bruchlast, wobei das Hilfsmaterial wie in einem der Ansprüche 7 bis 11 definiert ist.

14. Piezoelektrisches Vielschichtbauelement nach Anspruch 13, wobei das Vielschichtbauelement eine maximale Bruchspannung von 20 MPa, vorzugsweise 10 MPa, insbesondere bevorzugt 8 MPa besitzt.

15. Verwendung von ZrO₂, BaTiO₃ oder einer Mischung davon in der Hilfsmaterialschicht eines piezoelektrischen Vielschichtbauelements entsprechend Anspruch 13 oder 14 zur Verringerung der Bruchspannung.

## Claims

1. Method for producing a piezoelectric multilayer component, comprising the steps of:
A) providing an electrode material and green sheets containing a piezoelectric material,
B) providing an auxiliary material, which contains at least a first and a second component,
C) forming a stack (1), in which piezoelectric green sheets, at least one ply containing the auxiliary material and layers containing the electrode material are arranged one above another alternately,
D) sintering the stack (1),
wherein the first and second components of the auxiliary material chemically react during method step D), and the at least one ply is degraded.

2. Method according to the preceding claim, wherein the electrode material and the auxiliary material are selected in such a way that they contain the same metal, which is present in a smaller proportion in the electrode material than in the auxiliary material.

3. Method according to either of the preceding claims, wherein, in method step D), the first and second components react to form a third component and/or the first component decomposes into a third and a fourth component and the fourth component reacts with the second component to form the first component.

4. Method according to the preceding claim, wherein, in method step D), the third component and/or the first component diffuse toward at least one of the layers containing electrode material (20).

5. Method according to the preceding claim, wherein a weakening layer (21) is formed by the diffusion in the region of the ply in the stack (1).

6. Method according to one of the preceding claims, wherein CuO is selected as the first component, Cu is selected as the second component and a Cu alloy is selected as the electrode material.

7. Method according to one of the preceding claims, wherein the auxiliary material comprises a fifth component, which, at the preferred sintering temperatures for the piezoelectric material, in particular at most 1050°C, at most has a negligible sintering activity and does not react with the piezoelectric material used.

8. Method according to Claim 7, wherein the fifth component is a ceramic material.

9. Method according to Claim 7 or 8, wherein the fifth component comprises an element selected from the group consisting of zirconium dioxide, barium titanate and a mixture thereof.

10. Method according to one of Claims 7 to 9, wherein the fifth component comprises zirconium dioxide.

11. Method according to one of Claims 7 to 10, wherein the fifth component has a silicon content of at most 100 ppm.

12. Method according to one of Claims 7 to 11, wherein CuO is selected as the first component, Cu is selected as the second component, ZrO₂ is selected as the fifth component and a Cu alloy is selected as the electrode material.

13. Piezoelectric multilayer component comprising a plurality of alternating layers of electrode material and piezoelectric ceramic and at least one layer of auxiliary material having a breaking load which is reduced compared to the other layers of electrode material, wherein the auxiliary material is as defined in one of Claims 7 to 11.

14. Piezoelectric multilayer component according to Claim 13, wherein the multilayer component has a maximum breaking stress of 20 MPa, preferably 10 MPa, particularly preferably 8 MPa.

15. Use of ZrO₂, BaTiO₃ or a mixture thereof in the auxiliary material layer of a piezoelectric multilayer component corresponding to Claim 13 or 14 for reducing the breaking stress.

## Revendications

1. Procédé de fabrication d'un composant piézoélectrique multicouche comprenant les étapes consistant à :
A) fournir un matériau d'électrode et des feuilles vertes contenant un matériau piézoélectrique,
B) fournir un matériau auxiliaire contenant au moins un premier et un deuxième constituant,
C) former une pile (1) dans laquelle sont disposées en alternance les unes au-dessus des autres des feuilles vertes piézoélectriques, au moins une couche contenant le matériau auxiliaire et des couches contenant le matériau d'électrode,
D) fritter la pile (1),
dans lequel les premier et deuxième constituants du matériau auxiliaire réagissent chimiquement et l'au moins une couche se décompose lors de l'étape de procédé D).

2. Procédé selon la revendication précédente, dans lequel le matériau d'électrode et le matériel auxiliaire sont sélectionnés de manière à ce qu'ils contiennent un même métal qui est présent dans le matériau d'électrode dans une proportion inférieure à celle du matériau auxiliaire.

3. Procédé selon l'une quelconque des revendications précédentes, dans lequel, lors de l'étape D), les premier et deuxième constituants réagissent pour donner un troisième constituant et/ou le premier constituant se décompose en des troisième et quatrième constituants et le quatrième constituant réagit avec le deuxième constituant pour donner le premier constituant.

4. Procédé selon la revendication précédente, dans lequel, lors de l'étape D), le troisième constituant et/ou le premier constituant diffusent dans au moins l'une des couches contenant du matériau d'électrodes (20).

5. Procédé selon la revendication précédente, dans lequel une couche de fragilisation (21) est informée par diffusion dans la région de la couche dans la pile (1).

6. Procédé selon l'une quelconque des revendications précédentes, dans lequel du CuO est sélectionné en tant que premier constituant, du Cu est sélectionné en tant que deuxième constituant et un alliage de Cu est utilisé en tant que matériau d'électrode.

7. Procédé selon l'une quelconque des revendications précédentes, dans lequel le matériau auxiliaire comprend un cinquième constituant qui, aux températures de frittage préférées pour le matériau piézoélectrique, notamment à au plus de 1050°C, présente une activité de frittage minime et ne réagit pas avec le matériau piézoélectrique utilisé.

8. Procédé selon la revendication 7, dans lequel le cinquième constituant est un matériau céramique.

9. Procédé selon la revendication 7 ou 8, dans lequel ledit le cinquième constituant comprend un élément choisi dans le groupe constitué de l'oxyde de zirconium, du titanate de baryum et d'un mélange de ceux-ci.

10. Procédé selon l'une quelconque des revendications 7 à 9, dans lequel le cinquième composant comprend de l'oxyde de zirconium.

11. Procédé selon l'une quelconque des revendications 7 à 10, dans lequel le cinquième composant a une teneur en silicium d'au plus 100 ppm.

12. Procédé selon l'une quelconque des revendications 7 à 11, dans lequel du CuO est sélectionné en tant que premier constituant, du Cu est sélectionné en tant que deuxième constituant, du ZrO₂ est sélectionné en tant que cinquième constituant et un alliage de Cu est sélectionné en tant que matériau d'électrode.

13. Composant piézoélectrique multicouche comprenant une pluralité de couches alternées de matériau d'électrode et de céramique piézoélectrique et au moins une couche de matériau auxiliaire présentant une charge de rupture inférieure à celle des autres couches de matériau d'électrode, dans lequel le matériau auxiliaire est défini selon l'une quelconque des revendications 7 à 11.

14. Composant piézoélectrique multicouche selon la revendication 13, dans lequel le composant multicouche présente une contrainte de rupture maximale de 20 MPa, de préférence, de 10 MPa et plus préférentiellement, de 8 MPa.

15. Utilisation de ZrO₂, de BaTiO₃ ou d'un mélange de ceux-ci dans la couche auxiliaire de matériau d'un composant piézoélectrique multicouche selon la revendication 13 ou 14 pour réduire la contrainte de rupture.
